# EUROPEAN PATENT SPECIFICATION

(11) **EP 4 567 395 B1**
(45) Date of publication and mention of the grant of the patent: **29.07.2026**
(21) Application number: 24216761.7
(22) Date of filing: 02.12.2024
(51) Int. Cl.: G01L 9/00, G01L 19/14

(54) **SEALED MICROELECTROMECHANICAL MEMBRANE DEVICE**
ABGEDICHTETE MIKROELEKTROMECHANISCHE MEMBRANVORRICHTUNG
DISPOSITIF À MEMBRANE MICROÉLECTROMÉCANIQUE SCELLÉE

(30) Priority: 04.12.2023 IT 202300025878
(43) Date of publication of application: 11.06.2025
(73) Proprietor: STMicroelectronics International N.V., 1228 Plan-les-Ouates, Geneva (CH)
(72) Inventor: SHAW, Mark Andrew, 20133 Milano (IT); BALDO, Lorenzo, 20010 Bareggio (MI) (IT); DANIELE, Filippo, 20149 Milano (IT); ADORNO, Silvia, 20026 Novate Milanese (MI) (IT)
(74) Representative: Studio Torta S.p.A.

(56) References cited:
- US-A1- 2017 247 249
- US-A1- 2023 356 999

## Description

### Technical Field

The present invention relates to a sealed microelectromechanical (MEMS) membrane device and a method for manufacturing a sealed microelectromechanical membrane device.

### Background

As is known, an issue common to microelectromechanical membrane sensors, in particular to pressure sensors, relates to the effects of mounting operations. Generally, microelectromechanical membrane sensors and related control devices are manufactured into respective distinct semiconductor chips (a sensor chip and a control chip or ASIC - Application Specific Integrated Circuit - chip), which are bonded to a base and incorporated in a packaging structure. Subsequently, the base is soldered to a Printed Circuit Board or PCB for electrical and mechanical coupling to a user system.

In the absence of suitable measures, soldering causes significant thermal stress which, due to the different coefficients of thermal expansion, may deform the sensor chip and induce mechanical stresses on the membrane, leading to a drift in the sensing with respect to the calibration values.

To reduce the negative effects of thermal stress due to soldering, ceramic substrates are sometimes used as bases for assembling the sensor chip and the control chip. In fact, ceramic has the advantage of high stiffness and therefore deforms little with respect to polymeric substrates. On the other hand, ceramic substrates are expensive and do not allow the use of some advantageous and very common assembling techniques, such as flip chip or WLCSP (Wafer Level Chip Scale Package) techniques. The design freedom of membrane pressure sensors is thus limited.

According to a different solution, the membrane that operates as a transducer is formed in a suspended platform obtained from the sensor chip and connected thereto by flexures. The main portion of the sensor chip functions as a supporting body for the platform. The flexures may almost completely absorb the deformations of the sensor chip, as well as any shocks and vibrations, and preserve the membrane from stresses. However, if the solution is very effective in reducing the drift caused by thermomechanical stresses, it may be difficult to obtain other advantageous characteristics in many circumstances. In fact, in microelectromechanical pressure sensors, the membrane is in fluidic communication with the outside to be able to receive the pressure signals to be transduced, but, at the same time, it is often useful for the same membrane to be protected from potentially harmful agents, such as dust and humidity. Therefore, the sensitive portion of the microelectromechanical membrane device may be embedded in a potting gel, which has the property of conveying pressure variations from the outside and acts as a barrier for impurities. In sensors with suspended platform, however, waterproofing through gel deposition may be difficult to obtain. Since the interstices between the platform, the flexures and the supporting body have micrometric dimensions, the gel viscosity may make filling problematic and cause, for example, the formation of bubbles, which may affect the propagation and transduction of the pressure signals or make waterproofing ineffective. The structure with platform elastically coupled to the supporting body is therefore poorly compatible with waterproofing.

US 2017/247249 A1 discloses a microelectromechanical membrane sensor comprising a supporting body (2), containing semiconductor material and having a recess (8) in a face (2a), a platform (3), housed in the recess (8) at a distance from the supporting body (2), and a flexure (7), connecting the platform (3) to the supporting body (2) and configured to keep the platform (3) suspended in the recess (8). A gap (10) extends between the supporting body (2), the platform (3) and the flexure (7). A membrane (5) is housed in the platform (3) and delimits a buried cavity (11) incorporated in the platform (3).

Other examples of microelectromechanical membrane sensors are disclosed in US 2023/356999 A1.

### Summary

It is therefore an aim of the present invention to provide a microelectromechanical device and a method for manufacturing a microelectromechanical device which allow the limitations described to be overcome or at least mitigated.

According to the present invention, there are provided a microelectromechanical device and a method for manufacturing a microelectromechanical device as defined in claims 1 and 9, respectively.

### Brief Description of the Drawings

For a better understanding of the present invention, preferred embodiments are provided, by way of non-limiting example, with reference to the attached drawings, wherein:
- Figure 1 is a top-plan view of a microelectromechanical membrane sensor in accordance with an embodiment of the present invention;
- Figure 2 is a cross-section through the sensor of Figure 1, taken along line II-II of Figure 1;
- Figure 3 is a cross-section through a microelectromechanical pressure sensor in accordance with a different embodiment of the present invention;
- Figures 4-13 are cross-sections through a semiconductor wafer in subsequent processing steps of a process for manufacturing a microelectromechanical pressure sensor in accordance with an embodiment of the present invention; and
- Figures 14-15 are cross-sections through a semiconductor wafer in subsequent processing steps of a process for manufacturing a microelectromechanical pressure sensor in accordance with a different embodiment of the present invention.

### Description of Embodiments

The following description refers to the arrangement shown in the drawings; consequently, expressions such as "above", "below", "upper", "lower", "at the top", "at the bottom", "right", "left" and the like relate to the attached Figures and are not to be interpreted in a limiting manner.

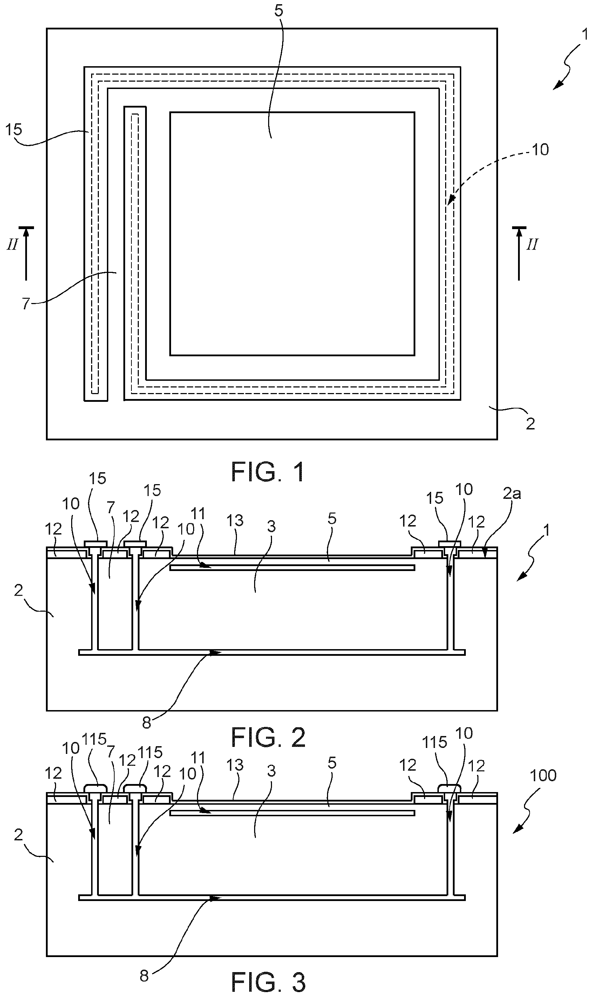

With reference to Figure 1, a microelectromechanical membrane sensor, in particular a pressure sensor, is indicated as a whole with the number 1 and comprises a supporting body 2 and a platform 3, which houses a membrane 5 and is connected to the supporting body 2 by a flexure 7.

The supporting body 2 is a die of semiconductor material, for example monocrystalline and/or polycrystalline silicon.

The platform 3 is housed in a recess 8 obtained in a major face 2a of the supporting body 2 and is kept suspended on a surface 2a of the same supporting body 2 by the flexure 7. More in detail, the platform 3 has generally a quadrangular, for example rectangular, shape and is spaced from the surface 2a.

In one embodiment, the flexure 7 is L-shaped and connects a vertex 3a of the platform 3 to the supporting body 2. A first branch 7a of the flexure 7 is anchored to the supporting body 2 and extends parallel to one side of the platform 3. A second branch 7b of the flexure 7, that is shorter, is consecutive and perpendicular to the first branch 7a and is bonded to the vertex 3a of the platform 3.

A spiral gap 10 laterally separates the platform 3 and the flexure 7 from the supporting body 2. In particular, the gap 10 runs between the supporting body 2 and the first branch 7a of the flexure 7, then along the second branch 7b and along three sides of the platform 3 and finally between the platform 3 and the first branch 7a, up to the second branch 7b of the flexure 7. For example, the gap may have a width comprised between 3 µm and 30 µm, in particular 7 µm in one embodiment.

The flexure 7 has a thickness substantially equal to the thickness of the platform 3 and is shaped so as to allow, within the limits imposed by the dimensions of the gap 10, so-called in-plane movements of the platform 3, that is, in the absence of deformations of the supporting body 2, movements substantially parallel to the major face 2a of the supporting body 2 (and of the platform 3). Out-of-plane movements, that is perpendicular to in-plane movements, are instead substantially prevented. Possibly, the flexure 7 may allow torsions around an axis of the first branch 7a, which may help accommodate deformations of the supporting body 2, for example following thermal stresses, without conveying significant strains to the platform 3.

The microelectromechanical pressure sensor 1 may also be provided with stoppers (not shown for simplicity) which further limit the movement of the platform 3.

The membrane 5 is formed on the platform 3 and closes a buried cavity 11, incorporated in the platform 3, on one side. In one embodiment, the buried cavity 11 is sealed by the membrane 5 and defines a pressure-controlled reference chamber. The membrane 5 is of semiconductor material, for example monocrystalline silicon, and may be capacitively coupled to one or more electrodes on the bottom of the buried cavity 11 or be provided with sensitive piezoresistive structures. On one side opposite to the buried cavity 11, the membrane 5 is exposed (directly or indirectly) to the pressure of the external environment. Conductive lines (not shown) run from the membrane 5 along the flexure 7 up to pads (not shown) and serve for the electrical coupling of the sensor 1 with the outside, for example an electronic system having the sensor 1 incorporated therein.

In one embodiment, a first dielectric layer 12, for example silicon oxide, covers the major face 2a of the supporting body 2, the flexure 7 and the platform 3 outside the membrane 5. A second dielectric layer 13, for example a thin silicon nitride layer, covers the major face 2a of the supporting body 2, the flexure 7 and the platform 3, including the membrane 5.

A sealing strip 15 extends along the gap 10 on the major face 2a of the supporting body 2 and, in part, on the flexure 7 and on the platform 3. The sealing strip 15 sealingly adheres to the supporting body 2, to the flexure 7 and to the platform 3 along the edges of the gap 10 and seals the gap 10 and the recess 8 having the platform 10 housed therein.

The sealing strip 15 is of a material having a low Young's modulus and a low coefficient of thermal expansion. In general, the material forming the sealing strip 15 has a Young's modulus lower than 300 MPa and a coefficient of thermal expansion lower than 250 ppm/°C.

In one embodiment, the sealing strip 15 is of a laminated polymeric material, for example dry resist.

According to a different embodiment, to which Figure 3 refers, in a microelectromechanical membrane pressure sensor 100 the sealing strip, here indicated by 115, is of an ultraviolet curable ink or UV-curable ink, deposited on the major face 2a of the supporting body 2, along the gap 10.

The sealing strip allows the sensor to be waterproofed, without appreciably affecting the thermomechanical stresses conveyed to the membrane. In practice, the presence of material across the gap maintains the decoupling of the platform from the supporting body as to the conveyance of the strains that may be generated following the deformation of the supporting body. The stresses produced by the assembling operations therefore do not give rise to significant drifts on the sensor output regardless of the base that is used. For example, with a width of the gap 10 of 7 µm, the combinations of values of the Young's modulus E and the coefficient of thermal expansion defined in Table 1 give rise to very low output drift values and in any case lower than 1 mbar

**Table 1**

| **E [MPa]** | **CTE [ppm/°C]** | **Drift [mbar]** |
|---|---|---|
| 10 | 30 | -0.00231 |
| 10 | 180 | -0.00563 |
| 100 | 100 | -0.59 |
| 150 | 100 | -0.98 |
| 200 | 30 | -0.404 |

On the one hand, therefore, waterproofed sensors may also be manufactured using less expensive bases than ceramic bases for assembling the sensor, because the deformations of the base do not affect the output owing to the fact that the membrane is formed on the movable platform. On the other hand, techniques for bonding the sensor to a support, in particular flip chip or WLCSP (Wafer Level Chip Scale Package) techniques, may also be used in a more flexible manner.

The selection of the Young's modulus and the lowest coefficient of thermal expansion in the ranges mentioned above ensures, on the one hand, that the gap remains effectively sealed and, on the other, that the sealing strip does not stiffen the structure to the point of conveying thermomechanical stresses from the supporting body to the platform and therefore the membrane. Furthermore, the sealing strip may contribute to the action of the stoppers which limit the displacements of the platform to avoid possible damage.

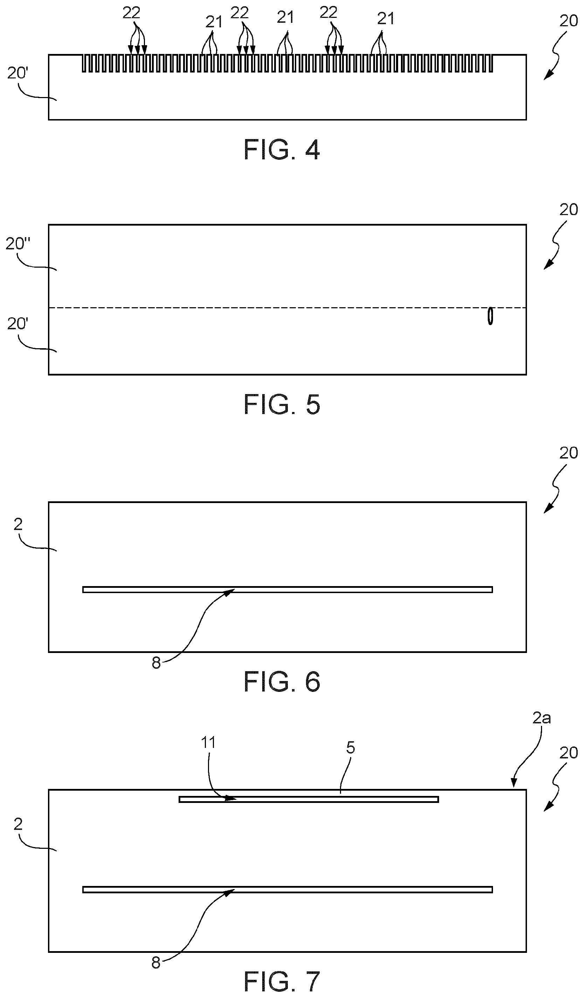

Figures 4-13 illustrate a process for manufacturing the sensor 1 of Figures 1 and 2 starting from a semiconductor wafer 20 comprising a substrate 20', for example of monocrystalline silicon. In an initial step (Figure 4), the substrate 20' is etched to form a grid or matrix of structures 21, for example pillars or walls, separated by trenches 22 in a region corresponding to a bottom of the recess 8, which will be defined below.

Subsequently (Figure 5), an epitaxial layer 20" of controlled thickness is grown and the trenches 22 are closed.

The material forming the structures 21 is redistributed by an annealing step and a cavity 23 is formed which substantially extends throughout the amplitude of the recess 8 (Figure 6).

By repeating the same technique (etch, epitaxial growth and annealing, Figure 7), the buried cavity 11 and the membrane 5 are then formed. In particular, the thickness of the membrane 5 may be determined by controlling the thickness of the new epitaxial layer, not illustrated here in detail. The substrate 20', the epitaxial layer 20" and the new epitaxial layer not shown define the supporting body 2 as it will be obtained at the end of the process, after dicing the wafer 20. For convenience, in Figures 7 and following, and in the related description, reference will be made to the supporting body 2. The conductive lines for the membrane and, according to design preferences, piezoresistive regions, also not illustrated, are then formed by processing steps not illustrated.

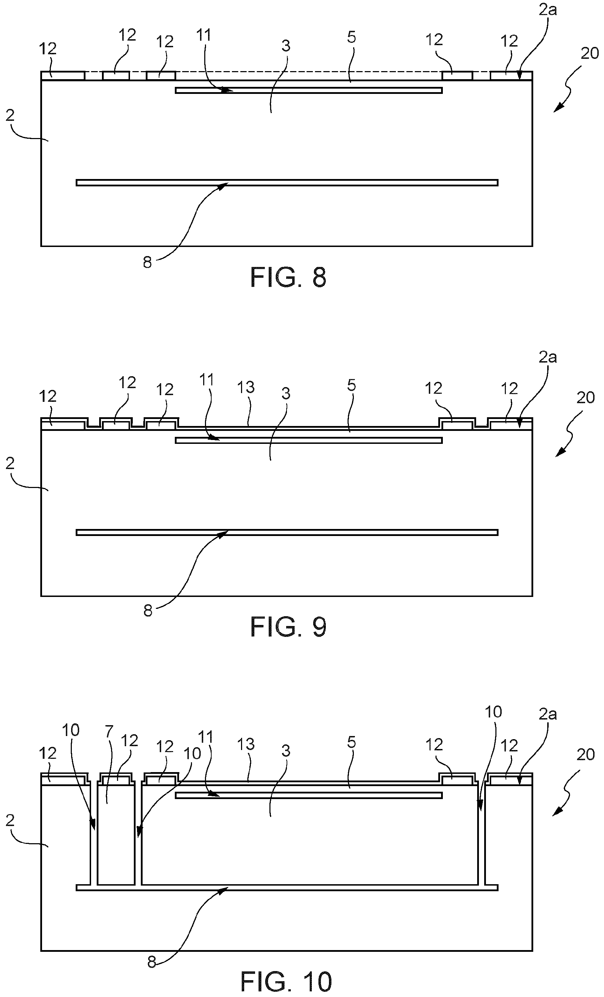

After having formed the buried cavity 11 and the membrane 5, the first dielectric layer 12 is deposited on the wafer 20 and selectively removed on the membrane 5 and along the path where the gap 10 will subsequently be formed (Figure 8).

The second dielectric layer 13 is conformally deposited on the wafer 20 (Figure 9).

As shown in Figure 10, an anisotropic etch, for example a trench etch, is then performed along the path of the gap 10, up to reaching at least the cavity 23 in depth. The trench etch opens the gap 10 and defines the platform 3, the flexure 7 and the recess 8.

However, it is understood that the structure obtained at this point may also be manufactured with alternative processes, for example using sacrificial dielectric layers to separate the platform 3 from the substrate 20 and to define the membrane 5.

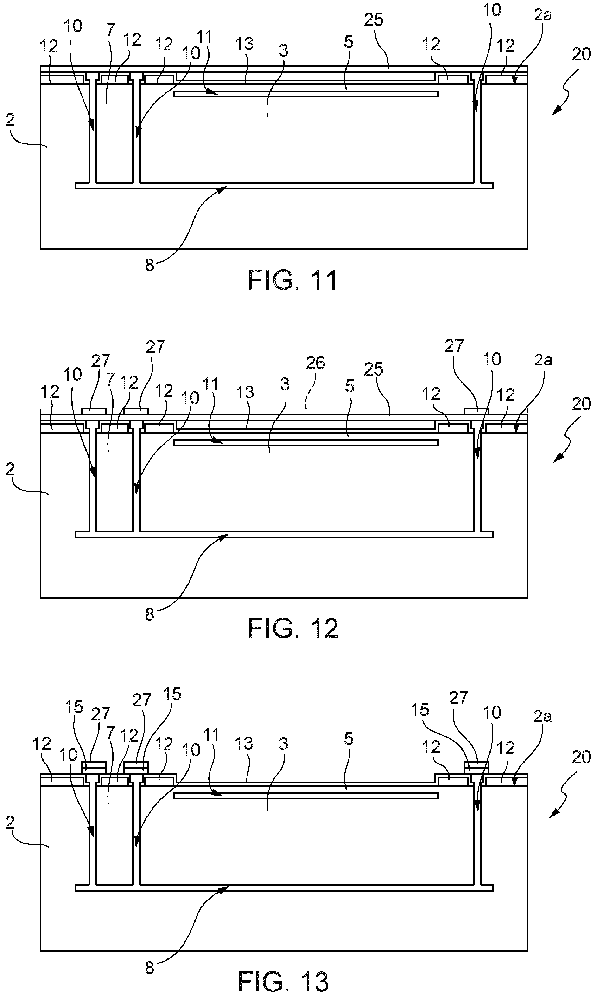

A sheet 25 of polymeric material, for example dry resist, is laminated onto the wafer 20 (Figure 11). The first dielectric layer 12 in this step also functions as a spacer and separates the sheet 25 from the membrane 5 and from the access of the gap 10.

A photoresist layer 26 is deposited on the sheet 25 and patterned by a photolithographic process, as shown in Figure 12, to form an etching mask 27 which covers the sheet 25 along the path of the gap 10 and has a shape corresponding to the sealing strip 15.

The photoresist layer 26 is exposed and selectively removed using the etching mask 27 to form the sealing strip 15 along the edges of the gap 10 (Figure 13).

The etching mask 27 is then removed and, after dicing the wafer 20, the structure of Figures 1 and 2 is obtained.

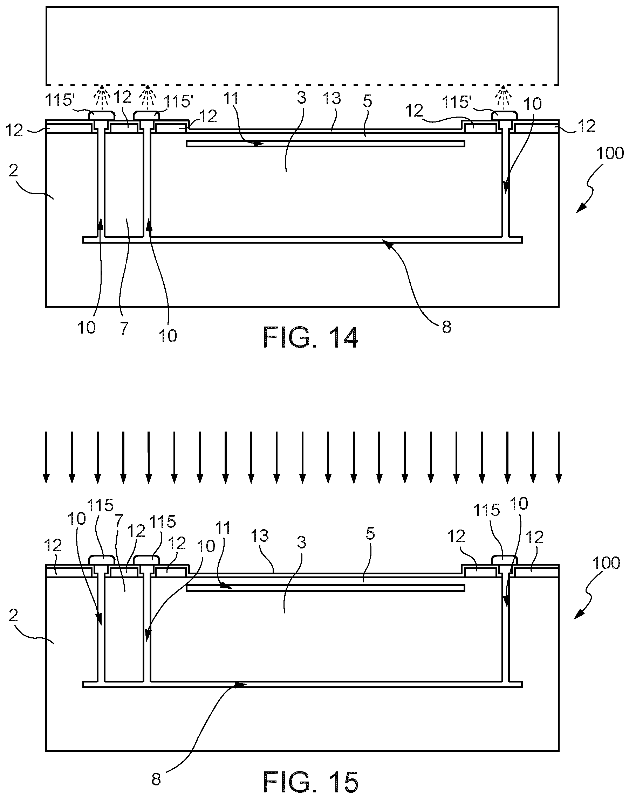

Alternatively, after opening the gap 10 and defining the platform 3, the flexure 7 and the recess 8, a strip 115' of UV-curable ink is deposited along the gap 10 (Figure 14). With a width of the gap 10 between 3 µm and 30 µm, as indicated above, the surface tension prevents the UV-curable ink from penetrating into the recess 8. After exposure to ultraviolet radiation which causes curing (Figure 15), the strip 115' partially hardens, remaining in the indicated Young's modulus range, and the structure of Figure 3 is obtained, with the sealing strip 115.

Finally, it is clear that modifications and variations may be made to the device and method described herein without thereby departing from the scope of the present invention, as defined in the attached claims.

For example, the connection of the platform to the supporting body at a single point and through a single flexure is particularly advantageous because it minimizes the strains conveyed to the platform and to the membrane in the event of deformation of the supporting body. However, it is not the only possible solution. According to design preferences, in fact, multiple flexures may be included, for example on opposite sides of the platform. In this case, the gap may be divided into multiple sections and for each section a respective sealing strip of the type described may be provided.

Furthermore, the materials forming the sealing strip are not limited to those described.

## Claims

1. A microelectromechanical membrane sensor comprising:
a supporting body (2), containing semiconductor material and having a recess (8) in a face (2a);
a platform (3), housed in the recess (8) at a distance from the supporting body (2);
a flexure (7), connecting the platform (3) to the supporting body (2) and configured to keep the platform (3) suspended in the recess (8), wherein a gap (10) extends between the supporting body (2), the platform (3) and the flexure (7);
a membrane (5) housed in the platform (3) and delimiting a buried cavity (11) incorporated in the platform (3); and
**characterized by** a sealing strip (15; 115) extending on the supporting body (2), on the platform (3) and on the flexure (7) along the gap (10) and sealingly adhering to the supporting body (2), to the flexure (7) and to the platform (3) along the edges of the gap (10).

2. The sensor according to claim 1, wherein the sealing strip (15; 115) is of a material having a Young's modulus lower than 300 MPa.

3. The sensor according to claim 1 or 2, wherein the sealing strip (15; 115) is of a material having a coefficient of thermal expansion lower than 250 ppm/°C.

4. The sensor according to any of the preceding claims, wherein the sealing strip (15) is a portion of a polymeric material sheet.

5. The sensor according to any of the preceding claims, wherein the sealing strip (15; 115) is of a material selected between dry resist and an UV-curable ink.

6. The sensor according to any of the preceding claims, wherein the platform (3) has a polygonal shape and wherein the flexure (7) has a first branch (7a), anchored to the supporting body (2) and extending parallel to one side of the platform (3), and a second branch (7b), consecutive to the first branch 7a and joined to the platform (3).

7. The sensor according to claim 6, wherein the gap (10) has a spiral shape and laterally separates the platform (3) and the flexure (7) from the supporting body (2).

8. The sensor according to claim 6 or 7, wherein the gap (10) runs between the supporting body (2) and the first branch (7a) of the flexure (7), around the platform (3) and between the platform (3) and the first branch (7a)and preferably has a width comprised between 3 µm and 30 µm.

9. A process for manufacturing a microelectromechanical membrane sensor comprising:
in a wafer (20) containing semiconductor material, forming a recess (8) in a face (2a), a platform (3), housed in the recess (8) at a distance from the supporting body (2), and a flexure (7), connecting the platform (3) to the supporting body (2) and configured to keep the platform (3) suspended in the recess (8), wherein a gap (10) extends between the supporting body (2), the platform (3) and the flexure (7);
forming a membrane (5) housed in the platform (3) and delimiting a buried cavity (11) incorporated in the platform (3); **characterized by**
forming a sealing strip (15; 115), extending on the supporting body (2), on the platform (3) and on the flexure (7) along the gap (10) and sealingly adhering to the supporting body (2), to the flexure (7) and to the platform (3) along the edges of the gap (10).

10. The process according to claim 9, wherein the sealing strip (15; 115) is of a material having a Young's modulus lower than 300 MPa.

11. The process according to claim 9 or 10, wherein the sealing strip (15; 115) is of a material having a coefficient of thermal expansion lower than 250 ppm/°C.

12. The process according to any of claims 9 to 11, wherein forming the sealing strip (15) comprises:
laminating a sheet (25) of polymeric material on the wafer (20);
forming a mask (27) covering the sheet (25) along the gap (10) and having a shape corresponding to the sealing strip (15); and
selectively exposing and removing the photoresist layer (26) using the mask (27).

13. The process according to any of claims 9 to 11, wherein forming the sealing strip (115) comprises:
depositing a UV-curable ink strip (115') along the gap (10);
exposing the UV-curable ink strip (115') to ultraviolet radiation, so as to cause curing.

## Patentansprüche

1. Mikroelektromechanischer Membransensor, umfassend:
einen Stützkörper (2), der Halbleitermaterial enthält und eine Aussparung (8) in einer Fläche (2a) aufweist;
eine Plattform (3), die in der Aussparung (8) in einem Abstand zum Stützkörper (2) untergebracht ist;
ein Biegeelement (7), das die Plattform (3) mit dem Stützkörper (2) verbindet und so eingerichtet ist, dass es die Plattform (3) in der Aussparung (8) aufgehängt hält, wobei sich ein Spalt (10) zwischen dem Stützkörper (2), der Plattform (3) und dem Biegeelement (7) erstreckt;
eine Membran (5), die in der Plattform (3) untergebracht ist und einen in der Plattform (3) integrierten vergrabenen Hohlraum (11) begrenzt; und
**gekennzeichnet durch** einen Dichtungsstreifen (15; 115), der sich am Stützkörper (2), an der Plattform (3) und am Biegeelement (7) entlang des Spalts (10) erstreckt und entlang der Kanten des Spalts (10) am Stützkörper (2), am Biegeelement (7) und an der Plattform (3) dichtend anhaftet.

2. Sensor nach Anspruch 1, wobei der Dichtungsstreifen (15; 115) aus einem Material mit einem Young'schen Modul von weniger als 300 MPa besteht.

3. Sensor nach Anspruch 1 oder 2, wobei der Dichtungsstreifen (15; 115) aus einem Material mit einem Wärmeausdehnungskoeffizienten von weniger als 250 ppm/°C besteht.

4. Sensor nach einem der vorhergehenden Ansprüche, wobei der Dichtungsstreifen (15) ein Abschnitt einer Polymermaterialplatte ist.

5. Sensor nach einem der vorhergehenden Ansprüche, wobei der Dichtungsstreifen (15; 115) aus einem Material besteht, das zwischen Trockenresist und einer UV-härtenden Tinte ausgewählt ist.

6. Sensor nach einem der vorhergehenden Ansprüche, wobei die Plattform (3) eine polygonale Form aufweist und wobei das Biegeelement (7) einen ersten Schenkel (7a) aufweist, der am Stützkörper (2) verankert ist und sich parallel zu einer Seite der Plattform (3) erstreckt, und einen zweiten Schenkel (7b), der dem ersten Schenkel 7a folgt und mit der Plattform (3) verbunden ist.

7. Sensor nach Anspruch 6, wobei der Spalt (10) spiralförmig ist und die Plattform (3) und das Biegeelement (7) seitlich vom Stützkörper (2) trennt.

8. Sensor nach Anspruch 6 oder 7, wobei der Spalt (10) zwischen dem Stützkörper (2) und dem ersten Schenkel (7a) des Biegeelements (7), um die Plattform (3) herum und zwischen der Plattform (3) und dem ersten Schenkel (7a) verläuft und vorzugsweise eine Breite zwischen 3 µm und 30 µm aufweist.

9. Verfahren zum Herstellen eines mikroelektromechanischen Membrandsensors, umfassend:
in einem Halbleitermaterial enthaltenden Wafer (20), Bilden einer Aussparung (8) in einer Fläche (2a), einer Plattform (3), die in der Aussparung (8) in einem Abstand zum Stützkörper (2) untergebracht ist, und eines Biegeelements (7), das die Plattform (3) mit dem Stützkörper (2) verbindet und so eingerichtet ist, dass es die Plattform (3) in der Aussparung (8) aufgehängt hält, wobei sich ein Spalt (10) zwischen dem Stützkörper (2), der Plattform (3) und dem Biegeelement (7) erstreckt;
Bilden einer Membran (5), die in der Plattform (3) untergebracht ist und einen in der Plattform (3) integrierten vergrabenen Hohlraum (11) begrenzt; **gekennzeichnet durch**
Bilden eines Dichtungsstreifens (15; 115), der sich am Stützkörper (2), an der Plattform (3) und am Biegeelement (7) entlang des Spalts (10) erstreckt und entlang der Kanten des Spalts (10) am Stützkörper (2), am Biegeelement (7) und an der Plattform (3) dichtend anhaftet.

10. Verfahren nach Anspruch 9, wobei der Dichtungsstreifen (15; 115) aus einem Material mit einem Young'schen Modul von weniger als 300 MPa besteht.

11. Verfahren nach Anspruch 9 oder 10, wobei der Dichtungsstreifen (15; 115) aus einem Material mit einem Wärmeausdehnungskoeffizienten von weniger als 250 ppm/°C besteht.

12. Verfahren nach einem der Ansprüche 9 bis 11, wobei das Bilden des Dichtungsstreifens (15) umfasst:
Laminieren einer Polymermaterialplatte (25) auf dem Wafer (20);
Bilden einer Maske (27), die die Platte (25) entlang des Spalts (10) abdeckt und eine Form aufweist, die dem Dichtungsstreifen (15) entspricht; und
selektives Freilegen und Entfernen der Photoresistschicht (26) unter Verwendung der Maske (27).

13. Verfahren nach einem der Ansprüche 9 bis 11, wobei das Bilden des Dichtungsstreifens (115) umfasst:
Auftragen eines UV-härtenden Tintenstreifens (115') entlang des Spalts (10);
Aussetzen des UV-härtenden Tintenstreifens (115') ultravioletter Strahlung, um eine Aushärtung zu bewirken.

## Revendications

1. Capteur à membrane microélectromécanique comprenant :
un corps de support (2) contenant un matériau semiconducteur et comportant un évidement (8) dans une face (2a) ;
une plateforme (3) placée dans l'évidement (8) à distance du corps de support (2) ;
un élément de flexion (7) reliant la plateforme (3) au corps de support (2) et configuré pour maintenir la plateforme (3) suspendue dans l'évidement (8), dans lequel un espace (10) s'étend entre le corps de support (2), la plateforme (3) et l'élément de flexion (7) ;
une membrane (5) placée dans la plateforme (3) et délimitant une cavité enfouie (11) incorporée dans la plateforme (3) ; et
**caractérisé par** une bande d'étanchéité (15 ; 115) s'étendant sur le corps de support (2), sur la plateforme (3) et sur l'élément de flexion (7) le long de l'espace (10) et adhérant de façon étanche au corps de support (2), à l'élément de flexion (7) et à la plateforme (3) le long des bords de l'espace (10).

2. Capteur selon la revendication 1, dans lequel la bande d'étanchéité (15 ; 115) est faite d'un matériau ayant un module de Young inférieur à 300 MPa.

3. Capteur selon la revendication 1 ou 2, dans lequel la bande d'étanchéité (15 ; 115) est faite d'un matériau ayant un coefficient de dilatation thermique inférieur à 250 ppm/°C.

4. Capteur selon l'une quelconque des revendications précédentes, dans lequel la bande d'étanchéité (15) est une partie d'une feuille de matériau polymère.

5. Capteur selon l'une quelconque des revendications précédentes, dans lequel la bande d'étanchéité (15 ; 115) est faite d'un matériau choisi entre une réserve sèche et une encre à séchage ultraviolet.

6. Capteur selon l'une quelconque des revendications précédentes, dans lequel la plateforme (3) a une forme polygonale et dans lequel l'élément de flexion (7) a une première branche (7a) solidaire du corps de support (2) et s'étendant parallèlement à un côté de la plateforme (3), et une deuxième branche (7b), dans la continuité de la première branche (7a) et reliée à la plateforme (3).

7. Capteur selon la revendication 6, dans lequel l'espace (10) a une forme de spirale et sépare latéralement la plateforme (3) et l'élément de flexion (7) du corps de support (2).

8. Capteur selon la revendication 6 ou 7, dans lequel l'espace (10) se trouve entre le corps de support (2) et la première branche (7a) de l'élément de flexion (7), autour de la plateforme (3) et entre la plateforme (3) et la première branche (7a) et a de préférence une largeur comprise entre 3 µm et 30 µm.

9. Procédé de fabrication d'un capteur à membrane microélectromécanique comprenant les étapes suivantes :
dans une plaquette (20) contenant un matériau semiconducteur, former un évidement (8) dans une face (2a), une plateforme (3) placée dans l'évidement (8) à distance du corps de support (2), et un élément de flexion (7) reliant la plateforme (3) au corps de support (2) et configuré pour maintenir la plateforme (3) suspendue dans l'évidement (8), dans lequel un espace (10) s'étend entre le corps de support (2), la plateforme (3) et l'élément de flexion (7) ;
former une membrane (5) placée dans la plateforme (3) et délimitant une cavité enfouie (11) incorporée dans la plateforme (3) ;
**caractérisé par** le fait de former une bande d'étanchéité (15 ; 115) s'étendant sur le corps de support (2), sur la plateforme (3) et sur l'élément de flexion (7) le long de l'espace (10) et adhérant de façon étanche au corps de support (2), à l'élément de flexion (7) et à la plateforme (3) le long des bords de l'espace (10).

10. Procédé selon la revendication 9, dans lequel la bande d'étanchéité (15 ; 115) est faite d'un matériau ayant un module de Young inférieur à 300 MPa.

11. Procédé selon la revendication 9 ou 10, dans lequel la bande d'étanchéité (15 ; 115) est faite d'un matériau ayant un coefficient de dilatation thermique inférieur à 250 ppm/°C.

12. Procédé selon l'une quelconque des revendications 9 à 11, dans lequel la formation de la bande d'étanchéité (15) comprend les opérations suivantes :
superposer une feuille (25) de matériau polymère sur la plaquette (20) ;
former un masque (27) couvrant la feuille (25) le long de l'espace (10) et ayant une forme correspondant à la bande d'étanchéité (15) ; et
exposer et retirer de manière sélective la couche photorésistante (26) en utilisant le masque (27).

13. Procédé selon l'une quelconque des revendications 9 à 11, dans lequel la formation de la bande d'étanchéité (115) comprend les opérations suivantes :
déposer une bande d'encre à séchage ultraviolet (115') le long de l'espace (10) ;
exposer la bande d'encre à séchage ultraviolet (115') à un rayonnement ultraviolet, afin de provoquer le séchage.
